**Europäisches Patentamt**

**European Patent Office**

**Office européen des brevets**

(19)

(11) Veröffentlichungsnummer: **0 058 934**
**B1**

(12) ## EUROPÄISCHE PATENTSCHRIFT

(45) Veröffentlichungstag der Patentschrift:
**25.04.84**

(51) Int. Cl.³: **H 03 J 7/32**

(21) Anmeldenummer: **82101184.8**

(22) Anmeldetag: **17.02.82**

(54) **Funkerfassungseinrichtung.**

(30) Priorität: **19.02.81 DE 3106037**

(43) Veröffentlichungstag der Anmeldung:
**01.09.82 Patentblatt 82/35**

(45) Bekanntmachung des Hinweises auf die Patenterteilung:
**25.04.84 Patentblatt 84/17**

(84) Benannte Vertragsstaaten:
**FR GB IT**

(56) Entgegenhaltungen:
**FR - A - 959 701**
**US - A - 3 449 749**

**MICROWAVE SYSTEMS NEWS, Band 6, Nr. 4,
September 1976, Seiten 45, 46, 48, Palo-Alto, USA,
ANON: "UP impact universal receivers"
NEWS FROM ROHDE & SCHWARZ, Band 15, Nr. 69,
1975, Seiten 8-12, München, DE. H. KNIRSCH et al.:
"VHF/UHF receiving system ET 001"**

(73) Patentinhaber: **Rohde & Schwarz GmbH & Co. KG,
Mühldorfstrasse 15, D-8000 München 80 (DE)**

(72) Erfinder: **Knirsch, Herbert, Fünfkirchenerstrasse 40,
D-8057 Erding (DE)**

(74) Vertreter: **Graf, Walter, Sckellstrasse 1,
D-8000 München 80 (DE)**

Funkerfassungseinrichtung

Die Erfindung betrifft eine Funkerfassungseinrichtung laut Oberbegriff des Hauptanspruches.

Einrichtungen dieser Art sind bekannt (US-PS 3 449 749 sowie Rohde & Schwarz-Firmenschrift »Nuevos Equipos de Radiovigilancia« mit Verwendung des Rohde & Schwarz-Automatikempfängers ESP). Mit Einrichtungen dieser Art soll ein möglichst vollständiges Bild der momentanen (heutigen, stündlichen, augenblicklichen) Funklage eines breiten Frequenzbereiches gewonnen werden, es soll festgestellt werden, wann, woher und von wem bestimmte Frequenzen in diesem breiten Frequenzbereich benutzt werden. Ferner soll der Nachrichteninhalt von ausgewählten interessierenden Sendern, die auf diese Weise durch Absuchen des Frequenzbandes festgestellt wurden, erfaßt und ausgewertet werden.

Es ist bekannt, für solche Funkerfassungseinrichtungen einen rechnergesteuerten Suchlaufempfänger zu verwenden, der in Frequenzschritten beispielsweise im Frequenzkanalraster der zu überwachenden Funkdienste quasi-kontinuierlich das zu überwachende Frequenzband überstreicht (Rohde & Schwarz-Empfänger ESP). Die Schaltzeiten der Frequenzschritte sind bei einem solchen Empfänger relativ kurz und es können auf diese Weise etwa 500 Kanäle pro Sekunde abgefragt werden.

Die Daten aller während des Suchvorgangs aufgefundenen Sender werden digital an einem Drucker oder an einem Sichtgerät einem Beobachter (Erfassungsleiter) angezeigt und dieser hat damit die Möglichkeit, aus diesen Daten diejenigen Sender auszuwählen, die gerade für eine Überwachung im Moment interessant sind. Er braucht dann nur noch die Frequenzdaten dieser ausgewählten Sender an festabgestimmte Überwachungsempfänger weiterzugeben, die an von Beobachtern besetzten Arbeitsplätzen abgehört werden. Diese Weitergabe von Senderdaten der vom Beobachter ausgewählten interessierenden Sender an die Überwachungsempfänger kann auch automatisch über den Rechner erfolgen, der den Suchlaufempfänger steuert.

Mit einer solchen bekannten Funkerfassungseinrichtung könnten nicht ohne weiteres breite Frequenzbereiche überwacht werden, die beispielsweise mit mehreren tausend Kanälen belegt sind, denn der Suchvorgang würde dann zu lange dauern und es bestünde die Gefahr, daß einige nur kurzzeitig aktive Sender während des Suchlaufs nicht erfaßt werden. Dies gilt vor allem dann, wenn auf den Kanälen Sender arbeiten, die jeweils nur sehr kurz einige zehntel Sekunden lang aktiv sind. Versuche, die Frequenzschritte des Suchlaufempfängers breiter zu machen, also je Schritt jeweils mehrere Kanäle zu erfassen (Grob-Frequenzsuche) konnten den Suchvorgang zwar beschleunigen, die Auffaßwahrscheinlichkeit war jedoch nicht ausreichend. Eine Aufteilung des Gesamtfrequenzbandes in mehrere Einzelbereiche würde einen nicht mehr tragbaren Geräteaufwand ergeben.

Selbst wenn mehrere momentan nicht interessierende Sender durch entsprechendes Programmieren des den Suchlauf eines solchen Empfängers steuernden Rechners unterdrückt würden, wie dies bei solchen Empfängern an sich möglich ist, könnte die Suchlaufzeit nicht ausreichend stark verkürzt werden, um derart viele Kanäle eines breiten Frequenzbandes sicher bezüglich Aktivitäten zu überwachen und abzuhören. Außerdem würde durch letztere Möglichkeit die Auffaßwahrscheinlichkeit stark reduziert, da ja nicht mehr das ganze Frequenzband laufend und lückenlos erfaßt würde.

Es ist Aufgabe der Erfindung, einen im Aufbau einfache Funkerfassungseinrichtung zu schaffen, die in einem breiten Frequenzband ständig alle Senderaktivitäten nahezu hundertprozentig erfaßt und mit der mit relativ wenigen Überwachungsempfängern die Aktivitäten von ausgewählten momentan interessierenden Sendern überwacht und ausgewertet werden können.

Diese Aufgabe wird ausgehend von einer Funkerfassungseinrichtung laut Oberbegriff des Hauptanspruches durch dessen kennzeichnende Merkmale gelöst. Vorteilhafte Weiterbildungen ergeben sich aus den Unteransprüchen.

Mit dem neben dem eigentlichen ständig das ganze Frequenzband quasi-kontinuierlich absuchenden Suchlaufempfänger vorgesehenen Abfrageempfänger, der vom Beobachter oder automatisch auf nur wenige beliebig im Frequenzband verteilte Sendefrequenzen programmiert ist und diese ständig nacheinander abfragt, ist es möglich, diesen für die Auswertung der interessierenden Sender nötigen Suchlauf zeitlich so zu verkürzen, daß mit Sicherheit auch sehr kurzzeitige Senderaktivitäten von beispielsweise nur einigen Zehntelsekunden erfaßt und durch automatisches Anschalten eines entsprechenden Überwachungsempfängers überwacht und ausgewertet werden können. Der eigentliche Suchlaufempfänger, mit dem alle im zu überwachenden Frequenzband auftretende Sender ständig nacheinander erfaßt und aufgezeichnet werden, arbeitet davon abhängig völlig selbständig weiter und sein Suchlauf braucht selbst nicht unterbrochen zu werden, er kann hierfür sogar einige Sekunden Zeit brauchen, da durch ihn ja nur ständig alle im Band auftretenden Sender festgestellt und aufgezeichnet werden müssen, von ihm jedoch nicht mehr die eigentliche Auslösung der Senderüberwachung und Nachrichtenauswertung gesteuert ist. Durch den nebenbei ständig fortgesetzten Suchlauf des Suchlaufempfängers wird weiterhin das ganze Band erfaßt und evtl. neu dort festgestellte Senderaktivitäten werden sofort dem Beobachter angezeigt, der dann aus dieser ergänzten Aufzeichnung bei Bedarf auch den Abfrageempfänger entsprechend neu programmieren kann, d. h. laufend weitere als interessant festgestellte Sender mit in die eigentliche Nachrichtenüberwachung aufnehmen kann. Eine erfindungsgemäße Funkerfassungseinrichtung besitzt daher eine nahezu hundertprozentige Auffaßwahrscheinlichkeit und ermöglicht bei minimalstem Geräteaufwand mit nur relativ wenigen festabstimmbaren Überwachungsempfängern das Abhören und Überwachen einer Vielzahl von interessierenden Nachrichtenkanälen. Mit dem zusätzlichen Abfrageempfänger können sehr schnell und mit optimaler Auffaßwahrscheinlichkeit eine Vielzahl von interessierenden Sender überwacht werden und nur dann, wenn auf einem der Kanäle tatsächlich eine Senderaktivität festgestellt wird, braucht einer der wenigen Überwachungsempfänger angeschaltet zu werden.

Eine erfindungsgemäße Einrichtung kann beispielsweise zur Überwachung des UHF-Flugfunkes mit Vorteil verwendet werden. Hier liegen beispielsweise 7000 Kanäle im Frequenzbereich von 225 bis 400 MHz. Davon sind momentan meist nur etwa 200 relevant und von diesen wieder nur max. 30 gleichzeitig aktiv. Zur Überwachung dieses ganzen breiten Frequenzbereiches sind daher beispielsweise nur 30 Überwachungsempfänger nötig, wenn diese über den Abfrageempfänger schnell genug umgeschaltet werden. Die Reduzierung der durch den Suchlauf im Frequenzbereich insgesamt festgestellten Sender auf die tatsächlich nur interessierenden Sender, zwischen denen dann der Abfrageempfänger umgeschaltet wird, geschieht im einfachsten Falle durch einen Beobachter, der anhand eines Schirmbildes die dort in bekannter Weise aufgezeichneten Sendefrequenzen des Frequenzbandes auswertet. Eine andere Möglichkeit besteht darin, das Ergebnis des Suchlaufes in Form einer Liste auszugeben. Der Beobachter wählt davon dann nur diejenigen Sender aus, die momentan (heute, stündlich, augenblicklich) gerade von Interesse sind und überwacht werden sollen. Diese Werte gibt der Beobachter dann in den Speicher für den Abfrageempfänger ein. Diese Reduzierung der Anzahl der zu überwachenden Sender kann natürlich auch mit geeigneten Einrichtungen automatisch erfolgen. So könnten beispielsweise die während des Suchlaufes festgestellten Sender über geeignete Einrichtungen automatisch auf Größe des Empfangspegels, Modulationsart oder auf die Feinfrequenzablage der tatsächlichen Empfangsfrequenz innerhalb des zugehörigen Frequenzkanals überwacht werden und in Abhängigkeit von diesen oder anderen zusätzlichen Kriterien dann selbsttätig bestimmt werden, welche der zahlreichen während des Suchvorganges festgestellten Sender für eine Überwachung interessant sind. Es brauchen dann nur noch die zugehörigen Frequenzwerte der so automatisch festgestellten interessierenden Sender in den Speicher für den Abfrageempfänger eingegeben zu werden. Die bei der erfindungsgemäßen Einrichtung vorgesehenen Zusatzschaltungen können in moderner Technik einfach und billig durch entsprechende Mikro prozessoren realisiert werden.

Die Erfindung wird im folgenden anhand einer schematischen Zeichnung an einem Ausführungsbeispiel näher erläutert.

Die erfindungsgemäße Funkerfassungseinrichtung umfaßt einen Suchlaufempfänger 1, der in bekannter Weise in seiner Empfangsfrequenz über einen Frequenzsynthesizer, der über einen Mikroprozessor 2 gesteuert ist, in Frequenzschritten abstimmbar ist und mit dem in Schritten quasikontinuierlich der ganze zu überwachende Frequenzbereich absuchbar ist. Die Größe der Frequenzschritte entspricht vorzugsweise dem Kanalraster des oder der Funkdienste, die in dem zu überwachenden Frequenzbereich arbeiten. Mit dem Prozessor 2 ist ein Sichtgerät 3 verbunden, auf dem alphanumerisch die Frequenzwerte und gegebenenfalls auch noch weitere Zusatzinformationen aller während des Suchvorganges aufgefundenen Sender angezeigt werden. Ein Beobachter (Erfassungsleiter 4) wertet diese sehr genau digital angezeigten Frequenzwerte des Suchlaufes aus und er bestimmt, welche dieser Sender beispielsweise heute gerade überwacht werden sollen. Er führt dies einerseits aufgrund der angezeigten Daten aus und aufgrund anderer vorhandener Informationen. Der Erfassungsleiter gibt dann über eine Tastatur des Sichtgerätes 3 die Daten derjenigen Sender ein, die überwacht werden sollen. Diese Dateneingabe wird dem Prozessor 2 zugeführt und aus diesem werden die diesen Sendern zugehörigen Frequenzdaten, die ja während des Suchlaufes festgestellt wurden und dort im Prozessor gespeichert sind, einem Abfrageprozessor 6 zugeführt, über den ein weiterer genauso wie der Empfänger 1 über einen Frequenzsynthesizer in Frequenzschritten abstimmbarer Überlagerungsempfänger 5 als Abfrageempfänger abstimmbar ist. Dieser Abfrageprozessor 6 wirkt als Speicher für die aus dem Suchlaufergebnis ausgewählten wenigen tatsächlich zu überwachenden Sendefrequenzen und der Empfänger 5 wird daher nur sprunghaft zwischen diesen ausgewählten Sendefrequenzen ungeschaltet. Er empfängt also in relativ kurzer Zeit nacheinander all diejenigen Sendefrequenzen, die vom Erfassungsleiter als interessant ausgewählt wurden. Da sowohl der Suchlauf als auch die Ansteuerung des Abfrageempfängers digital über Frequenzsynthesizer mit hoher Frequenzgenauigkeit erfolgt, ist sichergestellt, daß der Abfrageempfänger tatsächlich auch immer genau auf die digital ausgewählten Sendefrequenzen abgestimmt wird und keine weitere Korrektur von Hand nötig ist. Da mit dem Abfrageempfänger 5 nur relativ wenige Frequenzen abgefragt werden, ist gewährleistet, daß hierdurch alle auch relativ kurzen Funkaktivitäten auf diesen ausgewählten Sendefrequenzen erfaßt werden. Der Suchlaufempfänger 1 läuft dabei quasi-kontinuierlich weiter und liefert dauernd Informationen zur eventuellen Ergänzung der in den Speicher 6 eingegebenen Frequenzwerte. Der Erfassungsleiter hat damit die Möglichkeit, die tatsächlichen Abfragefrequenzen laufend zu ergänzen, was beispielsweise bei einem Wechsel des Frequenzplanes nötig wird.

Während des fortlaufenden Abfragens der ausgewählten Sender durch den Abfrageempfänger 5 wird über den Abfrageprozessor 6 gleichzeitig festgestellt, ob einer dieser Sender aktiv ist und beispielsweise eine Nachricht überträgt. Wird ein solcher aktiver Sender festgestellt, so wird die zugehörige im Prozessor 6 gespeicherte Frequenzinformation an einen jeweils freien Überwachungsempfänger einer mehrere, beispielsweise dreißig solche Überwachungsempfänger enthaltende Empfängereinheit 7 übergeben und dieser Überwachungsempfänger wird damit fest auf die jeweilige Sendefrequenz abgestimmt. Diese Überwachungsempfänger der Empfängereinheit 7 sind wieder über Frequenzsynthesizer digital in der Frequenz einstellbar, so daß auch bei dieser Übertragung der Sendefrequenz die einmal während des Suchvorganges gewonnene Frequenzgenauigkeit nicht verloren geht. Über den Prozessor 6 wird gleichzeitig auch noch ein Verteiler 8 so angesteuert, daß der zu einer im Prozessor 6 gespeicherten bestimmten Sendefrequenz zugehörige Nachrichteninhalt, also das NF-Ausgangssignal des gerade angeschalteten Überwachungsempfängers, immer an den gleichen Arbeitsplatz 9 von mehreren mit Beobachtern besetzten Arbeitsplätzen geschaltet wird, an denen über die Beobachter die über den Überwachungsempfänger 7 empfangenen Nachrichten ausgewertet werden. Außerdem werden die im Prozessor 6 gespeicherten Frequenzdaten den einzelnen Sichtgeräten 10 des ausgewählten Arbeitsplatzes 9 zugeführt und dort für den Beobachter gleichzeitig mit angezeigt.

Anstelle der Reduzierung der Sendefrequenzen auf wenige interessierende Sender durch den Erfassungsleiter 4 könnte auch eine geeignete automatische Auswerteinrichtung vorgesehen sein, durch welche die vom Prozessor 2 gelieferten digitalen Frequenzwerte nach Kriterien untersucht werden, die diese Frequenzen für eine Überwachung nötig erscheinen lassen. Dafür gibt es die verschiedenartigsten bekannten Auswertgeräte, mit denen beispielsweise eine Auswahl nach dem jeweiligen Empfangspegel durchgeführt wird (es werden nur Sender in den Prozessor 6 eingespeist, deren Empfangspegel einen vorbestimmten Schwellwert überschreitet), oder die während des Suchlaufs empfangenen Sender werden nach ihrer Modulationsart ausgewertet oder nach ihrer tatsächlichen Frequenzlage bezogen auf eine vorbestimmte genaue Sollfrequenz und in Abhängigkeit davon wird bestimmt, ob dieser Sender überwacht werden soll oder nicht.

Anstelle der beiden dargestellten gesonderten Mikroprozessoren 2 und 6 zum Steuern des Suchlaufes der Empfänger 1 und 5, bei denen es sich beispielsweise um die bei solchen Empfängern schon eingebauten Mikroprozessoren handeln kann, könnte auch ein einer solchen Gesamtanlage zugeordneter größerer Rechner verwendet werden, der die oben beschriebenen Funktionen dieser Prozessoren 2 und 6 und auch die Steuerung der Überwachungsempfänger und des Verteilers übernimmt.

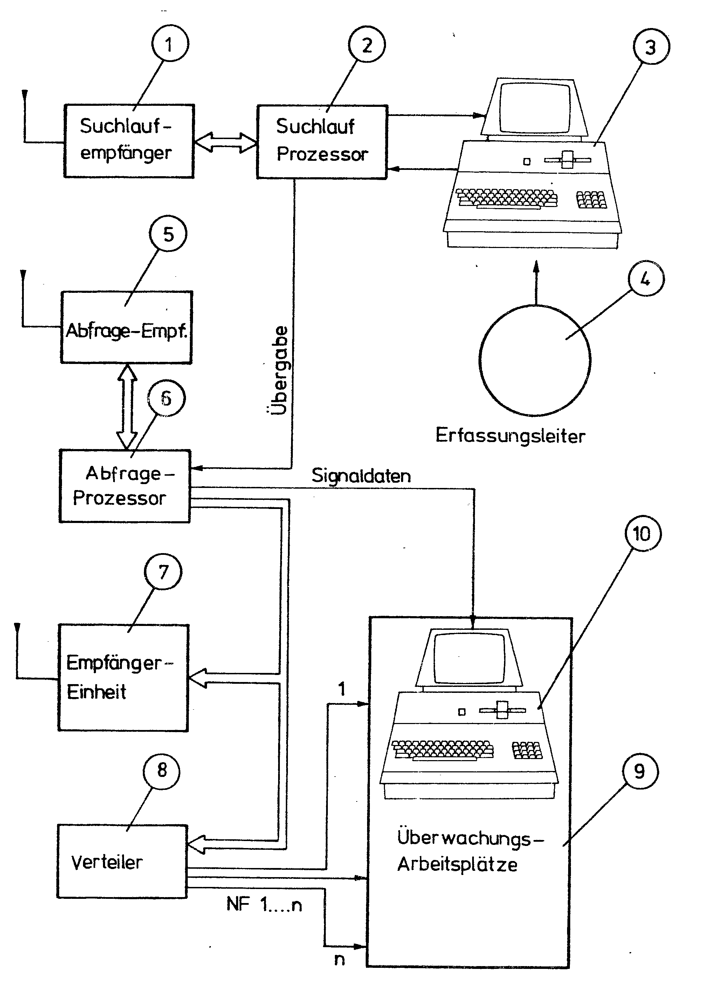

**Patentansprüche**

1. Funkerfassungseinrichtung mit einem den zu überwachenden Frequenzbereich überstreichenden Suchlaufempfänger (1) der gesteuert durch einen Rechner (2) in Frequenzschritten, insbesondere im Frequenzkanalraster der zu überwachenden Funkdienste, abstimmbar ist, wobei automatisch die Daten aller während des Suchlaufes im Frequenzbereich aufgefundenen Sender aufgezeichnet und im Rechner (2) gespeichert werden und bei welcher aus diesen im Rechner (2) gespeicherten Senderdaten vorbestimmte für die Überwachung interessante Sender auswählbar sind, auf die im Falle ihrer Aktivität einzelne rechnergesteuerte Überwachungsempfänger (7) abgestimmt werden, gekennzeichnet durch einen zusätzlichen rechnergesteuerten Abfrageempfänger (5), dessen Suchlaufsteuerung (6) auf die Frequenzwerte der wenigen ausgewählten und für die Überwachung interessanten Sender der durch den Suchlauf des Suchlaufempfängers (1) aufgefundenen Vielzahl von Sendern programmierbar ist, und die Überwachungsempfänger (7) von diesem nur wenige Sendefrequenzen absuchenden Abfrageempfänger (5) automatisch über eine Steuereinrichtung (6) auf die aktiven Sender abgestimmt und angeschaltet werden.

2. Einrichtung nach Anspruch 1 mit mehreren von Beobachtern besetzten Arbeitsplätzen (9) zum Auswerten der durch die Überwachungsempfänger (7) empfangenen Sendeaktivitäten, dadurch gekennzeichnet, daß über die vom Abfrageempfänger (5) gesteuerte Steuereinrichtung (6) eine mit den Ausgängen der Überwachungsempfänger (7) verbundene Verteilerschaltung (8) so gesteuert ist, daß der zu einer bestimmten Sendefrequenz gehörige Nachrichteninhalt stets zum gleichen Beobachter-Arbeitsplatz (9) geschaltet wird.

3. Einrichtung nach Anspruch 1 oder 2, bei der die Frequenzwerte des während des Suchlaufes des Suchlaufempfängers (1) empfangenen Sender alphanumerisch aufgelistet auf einem Schirmbild (3) angezeigt oder ausgedruckt werden, dadurch gekennzeichnet, daß die Frequenzwerte der mit dem Abfrageempfänger (5) abzusuchenden wenigen interessierenden Sender von einem Beobachter (4) abgelesen und von Hand in den Rechner (6) des Abfrageempfängers (5) eingegeben werden.

4. Einrichtung nach Anspruch 1 oder 2, dadurch gekennzeichnet, daß die Frequenzwerte der während des Suchlaufes des Suchlaufempfängers (1) empfangenen Sender über eine Auswerteinrichtung selbsttätig nach Kriterien untersucht werden, die für zu überwachende Sender charakteristisch sind, und über diese Auswerteinrichtung die Frequenzwerte der als interessant erkannten wenigen Sender in den Rechner (6) des Abfrageempfängers (5) automatisch eingespeichert werden.

## Claims

1. Radio monitoring system, including a search receiver (1) covering the frequency range to be monitored and tunable through computer (2) control in frequency steps — especially in steps corresponding to the frequency channel spacing of the radio services to be monitored — wherein the data of all transmitters detected during the searching process within the frequency range are automatically recorded and stored in the computer (2) and predetermined transmitters of interest for monitoring can be selected from the data stored in the computer (2) in such a way that individual computer-controlled monitoring receivers (7) are tuned to the selected transmitters while they are active, characterized by an additional computer-controlled scanning receiver (5) whose scanning control circuit (6) can be programmed to the frequencies of the few transmitters of interest selected from the great number of transmitters detected through the scanning process of the search receiver (1), and wherein the monitoring receivers (7) are automatically tuned to the active transmitters and switched on via the control circuit (6) by the said scanning receiver (5), which only scans a few transmitter frequencies.

2. System according to Claim 1, including several monitoring stations (9) occupied by observers evaluting the transmitter information received by the monitoring receivers (7), characterized in that a distribution circuit (8) connected to the outputs of the monitoring receivers (7) is controlled via the control circuit (6) from the scanning receiver (5) in such a manner that the information content pertaining to a particular transmitter frequency is always switched to the same monitoring station (9).

3. System according to Claim 1 or 2, wherein the frequencies of the transmissions received during the searching process of the search receiver (1) are listed alphanumerically on a screen display or print, characterized in that the frequencies of the few interesting transmitters to be scanned by the scanning receiver (5) are read by an observer (4) and manually entered into the computer (6) of the scanning receiver (5).

4. System according to Claim 1 or 2, characterized in that the frequencies of the transmitters received during the searching process of the search receiver (1) are automatically checked via an evaluation unit according to criteria which are typical of transmitters to be monitored, and that the frequencies of the few transmitters found to be of interest are automatically stored in the computer (6) of the scanning receiver (5) via this evaluation unit.

## Revendications

1. Installation de surveillance d'émetteurs radio ayant un récepteur de recherches de données (1) qui balaie la gamme de fréquences à surveiller et qui, gouverné par un microprocesseur (2) dans la série de fréquences, en particulier dans le réseau du canal de fréquence du service radioélectrique à surveiller, est réglable, dans laquelle les données de tous les émetteurs découverts pendant la sélection dans la gamme de fréquences sont notées automatiquement et enmagasinées dans le microprocesseur (2) et dans lesquelles on peut, dans le microprocesseur (2), choisir des données déterminées d'émetteurs pour la surveillance d'émetteurs intéressants, sur lesquelles, dans le cas de leur activité, des récepteurs de surveillance (7) individuels contrôlés par des calculateurs sont déterminés, caractérisée par un récepteur de demande (5) contrôlé par un calculateur supplémentaire dont la commande de recherches de données (6) sur les valeurs de fréquence des quelques émetteurs choisis et intéressants pour la surveillance de la sélection du récepteur de recherche de données (1) trouvée par le grand nombre d'émetteurs peut être programmée, et par les récepteurs de surveillance (7) du récepteur de demande (5) qui ne cherchent que peu de fréquences d'émission et sont automatiquement syntonisées par un dispositif de commande (6) sur l'émetteur actif coordonné et branché sur l'émetteur actif.

2. Installation suivant la revendication 1, ayant plusieurs lieux de travail (9) occupés par des observateurs pour évaluer les activités d'émissions reçues par les récepteurs de surveillance (7), caractérisée en ce que grâce au dispositif (6) commandé par le récepteur de demande (5), un montage répartiteur (8) relié aux sorties des récepteurs de surveillance (7) est réglé de façon que le contenu des nouvelles appartenant à une fréquence d'émission déterminée soit toujours relié au même lieu de travail de l'observateur (9).

3. Installation suivant l'une des revendications 1 et 2, dans laquelle les valeurs de fréquence de l'émetteur (1) reçues pendant la recherche de données du récepteur alphanumérique de recherches de données sont indiquées ou exprimées sur un oscillogramme (3), caractérisée en ce que les valeurs de fréquences des émetteurs qui, avec le récepteur de demande (5), cherchent des émetteurs peu intéressants sont lues par un observateur (4) et sont présentées dans le dispositif (6) du récepteur de demande (5).

4. Installation suivant l'une des revendications 1 et 2, caractérisée en ce que les valeurs de fréquences de l'émetteur reçues pendant la recherche de données du récepteur de recherches de données (1) sont cherchées automatiquement par un dispositif de sélection suivant des critères qui sont caractéristiques pour l'émetteur à sur-

**0 058 934**

veiller, et en ce que, par ce dispositif de sélection, les valeurs de fréquences des quelques émetteurs considérés comme intéressants sont automatiquement mises en mémoire dans l'ordinateur (6) du récepteur de demande (5).

① Suchlauf-empfänger

② Suchlauf Prozessor

③

④ Erfassungsleiter

⑤ Abfrage-Empf.

⑥ Abfrage-Prozessor

Übergabe

Signaldaten

⑦ Empfänger-Einheit

⑧ Verteiler

NF 1....n

⑩

⑨ Überwachungs-Arbeitsplätze

1

n